# EUROPEAN PATENT APPLICATION

(11) **EP 4 386 835 A1**
(43) Date of publication of application: **19.06.2024**
(21) Application number: 23203411.6
(22) Date of filing: 13.10.2023
(51) Int. Cl.: H01L 23/525, G11C 17/16, H01L 23/62, H10B 20/00

(54) **ANTIFUSE DEVICES AND METHODS OF MAKING THEREOF**

(30) Priority: 14.12.2022 US 202218065632
(71) Applicant: GLOBALFOUNDRIES Singapore Pte. Ltd., Singapore 738406 (SG)
(72) Inventor: Lee, Shu Hui, 738406 Singapore (SG); Tan, Juan Boon, 738406 Singapore (SG); Sun, Jianxun, 738406 Singapore (SG); Maung, Myo Aung, 738406 Singapore (SG); Balan, Hari, 738406 Singapore (SG)
(74) Representative: Grünecker Patent- und Rechtsanwälte PartG mbB

(57) **Abstract**

An antifuse device has a first contact structure and a second contact structure in a substrate.

The first contact structure has a first contact side adjoining a second contact side and forming a first contact corner having an acute angle. The second contact structure is spaced from and not electrically connected to the first contact structure. The antifuse device further includes a first dummy structure in the substrate, adjacent to the first contact structure. The first dummy structure has a first dummy side nearest to and spaced from the first contact side of the first contact structure.

## Description

### FIELD OF THE INVENTION

The present invention relates generally to antifuse devices, and more particularly to antifuse devices and methods of making antifuse devices.

### BACKGROUND

Fuses and antifuses are commonly used in electronic circuits to selectively enable or disable certain features or sections of the circuits. Fuses are designed to permanently break an electrically conductive path, for example, when the current through the path exceeds a predetermined limit, thus rerouting the electrical signal through another intended section of the circuitry. Antifuses are electrical devices that perform in an opposite manner compared to a fuse. Antifuses are designed to create a conductive path, for example, when a voltage across the antifuse exceeds a certain level. In semiconductor devices, antifuses may be useful for permanently programming selected integrated circuits.

As semiconductor devices continue to shrink in size, the processing of antifuses becomes increasingly challenging as the spacing between features becomes smaller and more difficult to form. Improved antifuse devices and methods of making such antifuse devices are therefore required.

### SUMMARY

According to an embodiment of the invention, an antifuse device comprises a first contact structure in a substrate, the first contact structure having a first contact side and a second contact side adjoining the first contact side, wherein the first contact side and the second contact side forms a first contact corner having an acute angle. The antifuse device further comprises a second contact structure in the substrate, wherein the second contact structure is spaced from and not electrically connected to the first contact structure, and a first dummy structure adjacent to the first contact structure and in the substrate, the first dummy structure having a first dummy side nearest to and spaced from the first contact side of the first contact structure.

According to another embodiment of the invention, an antifuse device comprises a first contact structure in a substrate, the first contact structure having a first contact side and a second contact side adjoining the first contact side, wherein the first contact side and the second contact side forms a first contact corner having an acute angle. The antifuse device further comprises a second contact structure in the substrate, wherein the second contact structure is spaced from and not electrically connected to the first contact structure, and a first dummy structure adjacent to the first contact structure and in the substrate, the first dummy structure having a first dummy side nearest to and spaced from the first contact side of the first contact structure. The antifuse device further comprises a second dummy structure adjacent to the first contact structure and in the substrate, the second dummy structure having a second dummy side nearest to and spaced from the second contact side of the first contact structure by a second spacing, and wherein the first spacing is substantially the same as the second spacing.

According to yet another embodiment of the invention, a method of fabricating an antifuse device comprises the forming of a first contact structure in a substrate, the first contact structure having a first contact side and a second contact side adjoining the first contact side, wherein the first contact side and the second contact side forms a first contact corner having an acute angle. The method further comprises the forming of a second contact structure in the substrate, wherein the second contact structure is spaced from and not electrically connected to the first contact structure, and a first dummy structure adjacent to the first contact structure and in the substrate, the first dummy structure having a first dummy side nearest to and spaced from the first contact side of the first contact structure.

### BRIEF DESCRIPTION OF THE DRAWINGS

The accompanying drawings illustrate examples of various non-limiting embodiments of the invention and constitute a part of the specification. The drawings, along with the above general description of the invention, and the following detailed description of the various embodiments, serve to explain the examples of the non-limiting embodiments of the invention. In the drawings, like reference numerals generally refer to like features in the various views.
FIG. 1A shows a simplified plan view of an antifuse device 100, according to an exemplary embodiment of the invention.
FIG. 1B shows a simplified cross-sectional view of the antifuse device 100 in FIG. 1A, taken along line A-A'.
FIG. 2A shows a simplified plan view of an antifuse device 100 after being activated, according to an aspect of an exemplary embodiment of the invention.
FIG. 2B shows a simplified cross-sectional view of the antifuse device 100 in FIG. 2A, taken along line B-B'.
FIG. 3A shows a simplified plan view of antifuse device 200, according to an alternative exemplary embodiment of the invention.
FIG. 3B shows a simplified plan view of antifuse device 300, according to another alternative exemplary embodiment of the invention.
FIGS. 4A - 4D show simplified cross-sectional views representing exemplary process steps for fabricating the antifuse device 100, according to exemplary embodiments of the invention.
FIG. 5 shows a simplified layout of an array of antifuse devices, according to an exemplary embodiment of the invention.

For simplicity and clarity of illustration, the drawings illustrate the general manner of construction, and certain descriptions and details of well-known features and techniques may be omitted to avoid unnecessarily obscuring the discussion of the described embodiments of the device. Additionally, elements in the drawings are not necessarily drawn to scale and the dimensions of some of the elements in the drawings may be exaggerated relative to other elements to help improve understanding of the embodiments of the device.

### DETAILED DESCRIPTION

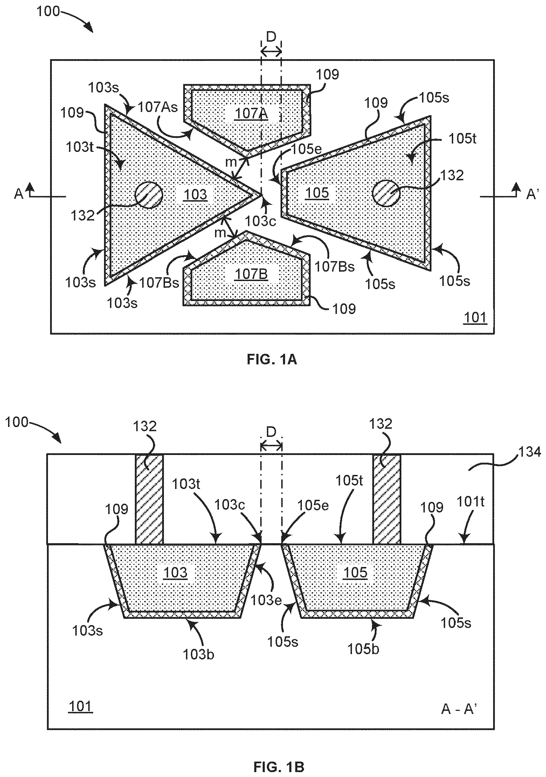

FIG. 1A shows a simplified plan view of an antifuse device 100, according to an exemplary embodiment of the invention. The antifuse device 100 includes contact structures 103 and 105, formed in a substrate 101. In some embodiments, the substrate 101 may include a suitable integrated circuit (IC) semiconductor substrate, including but is not limited to silicon, germanium, silicon germanium (SiGe), silicon carbide, gallium arsenide, silicon-on-insulator (SOI) substrates. In other embodiments, substrate 101 may include the dielectric layers in the back-end-of-line (BEOL) layers of a semiconductor device. In some embodiments, substrate 101 may be an undoped substrate. In some other embodiments, substrate 101 may be doped with a dopant, such as n-type or p-type dopants. Contact structures 103 and 105 may each be connected to conductive lines or vias 132 that are in turn connected to separate electrical voltage or current sources that may be programmed as required. Contact structure 103 is spaced from contact structure 105 such that there is no electrical connection between the two contact structures. In an embodiment, contact structure 103 may be laterally spaced from and adjacent to contract structure 105. When viewed from the top, contact structure 103 may have a plurality of sides 103s adjoining each other to define a border encircling the top surface 103t of the contact structure 103. In an embodiment, the contact structure 103 may comprise at least 3 sides 103s to form a triangular-shaped top surface 103t having a corner 103c that is the nearest to contact structure 105. In an embodiment, corner 103c may have an acute angle. Sides 103s adjoin each other to form at least 3 edges, including edge 103e that is adjacent to and nearest to contact structure 105 compared to other edges. Edge 103e includes corner 103c has the shortest distance D from contact structure 105, for example, from the nearest edge 105e of contact structure 105. In some embodiments, the distance D may be the shortest distance between the corner 103c and a point on contact structure 105 that is nearest to contact structure 103, which may be a corner or an edge of contact structure 105. In other embodiments, the contact structure 103 may comprise more than 3 sides to form polygonal-shaped top surface 103t. In an embodiment, the sides 103s may comprise straight or substantially straight lines. In other embodiments, the sides 103s may comprise curved lines or a combination of curved and straight lines. In some embodiments, contact structures 103 and 105 may include a barrier liner 109 directly on the sides 103s and 105s respectively of the contact structure, such that the barrier liner encircles the border of the contact structure 103. Contact structure 105 may also comprise at least 3 sides 105s adjoining each other to define a border encircling the top surface 105t of the contact structure 105. In some embodiments, contact structure 105 may be substantially similar to contact structure 103 and have a corner 105c (not shown) that is nearest to corner 103c of contact structure 103. In other embodiments, contact structure 105 may have a different number of sides 105s and a top surface 105t having a different shape from the top surface 103t. For example, contact structure 105 may have 3 sides 103s while contact structure 105 may have 4 sides, such that top surface 103t may have a triangular shape while top surface 105t may have a trapezoidal shape, in which case the contact structure 105 may have an edge 105e that is nearest to corner 103c of contact structure 103 (see FIG. 1B). Edge 105e may be on the side 105s that is nearest to contact structure 103 compared to the other sides. Contact structures are formed from a conductive material including, for example, polysilicon, metal silicides, copper, aluminum, alloys thereof, or any other suitable conductive material. The barrier liner may include a suitable metal or compounds thereof, for example, tantalum nitride, titanium nitride, or any other suitable metals.

Still referring to FIG. 1A, the antifuse device 100 may further include dummy structures 107A and 107B, with both dummy structures being immediately adjacent to and spaced from contact structures 103 and 105, such that there are no intervening structures between a dummy structure, for example, dummy structure 107A, and a contact structure, for example, contact structure 105. Dummy structures are not connected to any voltage sources and do not provide any electrical connections. There is no electrical connection between a dummy structure and either of the contact structure. For example, dummy structure 107A is immediately adjacent to and spaced from and has no electrical connection with contact structures 103 and 105. In another example, dummy structure 107B is immediately adjacent to and spaced from and has no electrical connection with contact structures 103 and 105. During the design stage, dummy structures 107A and 107B may be designed to be spaced from the contact structures 103 and 105 by at least the minimum design rule spacing that is allowable for the relevant technology node. After processing, the actual dummy structures 107A and 107B formed are spaced from contact structures 103 and 105 by a distance m, wherein m has a value that is more than the minimum design rule spacing stipulated in the device design. For example, the actual dummy structure 107A may have a side 107As that is immediately adjacent to and spaced from side 103s of contact structure 103 at the nearest point, by a distance m that is more than the minimum design rule spacing. In some embodiments, the distance m differs from the minimum design rule spacing by a value within a range of 1 to 20 nanometers. Similarly, the actual dummy structure 107B may also have a side 107Bs may also have a side 107Bs that is immediately adjacent to and spaced from the side 103s of contact structure 103 at the nearest point, by a distance m that is more than the minimum design rule spacing. This is due to the proximity effect in lithography and allows for the formation of a narrower or finer tip or corner for contact structure 103, as compared to the width of a similarly shaped contact structure that may be obtained without the presence of adjacent dummy structures. For example, due to the lithography proximity effect, the sides 103s are spaced from the sides 107As and 107Bs by more than the minimum design rule spacing after processing. As a result, the sides 103s are formed closer to each other than the 103s-to-103s spacing originally stipulated in the device design and thus defines a narrower or finer corner 103c. Similarly, the proximity effect may also be utilized on contact structure 105 to form a correspondingly narrower or finer corner 105c as aforementioned. In some embodiments, the dummy structures may include a barrier liner 109 directly on the sides of each of the dummy structures, such that the barrier liner encircles the border of the dummy structures 107a and 107b, similar to the contact structures as aforementioned. Dummy structures may comprise the same material as contact structures in an embodiment or may comprise different materials in other embodiments.

Now referring to FIG. 1B, which shows a simplified cross-sectional view of the antifuse device 100 in FIG. 1A, taken along line A-A'. The substrate 101 has a top surface 101t, which is coplanar or substantially coplanar with the top surface 103t of the contact structure 103 and the top surface 105t of the contact structure 105, such that contact structures 103 and 105 are arranged in the substrate 101. Although not shown in FIG. 1B, it may be understood that as a result of the dummy structures being formed with the same process steps as the contact structures, the dummy structures also have top surfaces that may be coplanar or substantially coplanar with the top surface 101t of the substrate. In an embodiment, the corner or edge of contact structures 103 and 105 that are nearest to each other, for example, the corner 103c of contact structure 103 and the edge 105e of contact structure 105, are both located at the same height as the top surface 101t of the substrate. Contact structures 103 and 105 each have a bottom surface 103b and 105b respectively, both of which are below the top surface 1011 of the substrate. Bottom surface 103b adjoins the lower end of each side 103s, and bottom surface 103b may have substantially the same shape as top surface 103t but may have a smaller area than top surface 103t, such that the cross-sectional profile of contact structure 103 has a trapezoidal shape as shown in FIG. 1B. Bottom surface 105b similarly adjoins the lower end of each side 105s, and bottom surface 105b may have substantially the same shape as top surface 105t but may also have a smaller area than top surface 105t, such that the cross-sectional profile of contact structure 105 has a trapezoidal shape. In some embodiments, the contact structures and dummy structures include a continuous barrier liner 109 each on the sides and bottom surface of each contact structure. In such embodiments, the barrier liner 109 is in direct contact with substrate 101 at the sides and bottom surfaces of the contact structures and dummy structures.

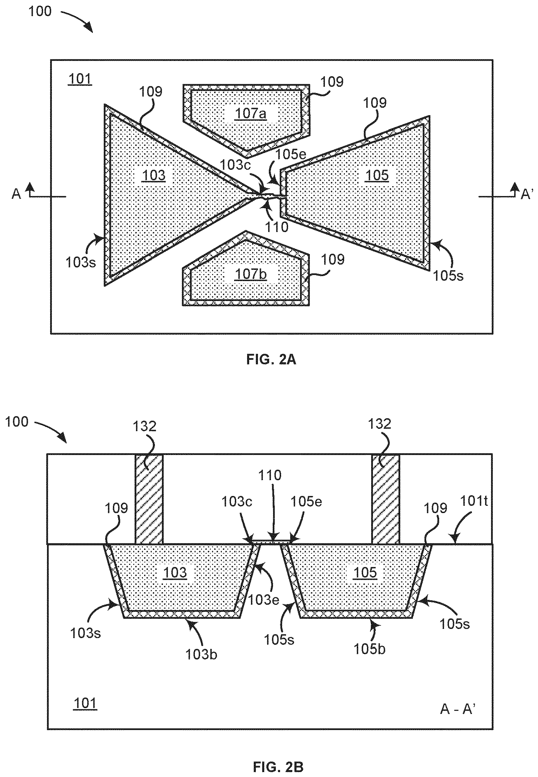

Next referring to FIGS. 2A and 2B which show the simplified plan view and corresponding simplified cross-sectional view of the antifuse device 100 after being activated, for example, after the formation of conductive link 110 between contact structures 103 and 105, in accordance with an aspect of an exemplary embodiment of the invention. The conductive link 110 is formed after a sufficiently large programming current is applied to the contact structures 103 and 105 such that the localized charge concentrations are formed at the corner or edge of contact structures 103 and 105 that are nearest to each other. This eventually results in the formation of a permanent conductive link 110 due to, for example, material diffusion or electromigration of atoms or ions of the conductive material in the contact structures 103 and 105. Electrical signals may thereafter pass through the permanent conductive link between contact structures 103 and 105. In an embodiment, the conductive link 110 is formed along the interface of the substrate 101 and the dielectric layer 134, between the corner 103c of contact structure 103 nearest to contact structure 105, and the edge 105e of contact structure 105 nearest to contact structure 103. In another embodiment (not shown), the conductive link 110 is formed between the corner 103c of contact structure 103 nearest to contact structure 105, and the corner 105c of contact structure 105 nearest to contact structure 103.

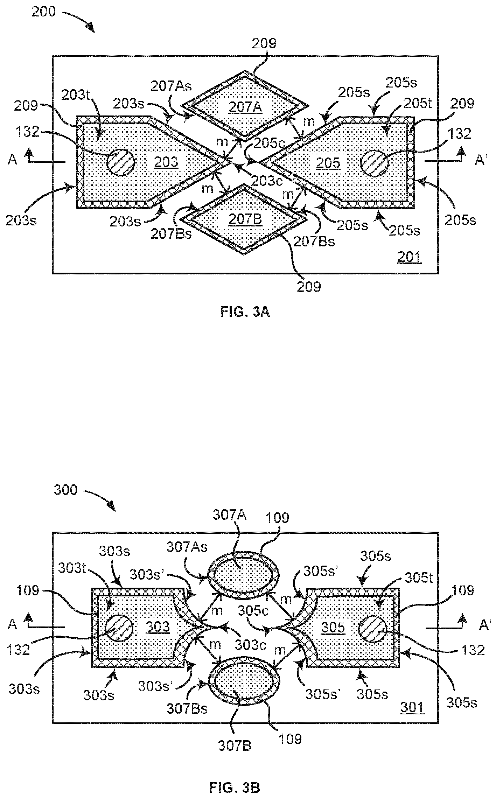

FIG. 3A shows a simplified plan view of antifuse device 200 in accordance with an alternative exemplary embodiment, and in which like reference numerals refer to like features in FIG. 1A. The antifuse device 200 may have features similar to antifuse device 100, but may include contact structures 203 and 205 each having a different shape from contact structures 103 and 105. For example, contact structure 203 and contact structure 205 may each have a polygonal shape with sides 203s and 205s respectively. Sides 203s adjoin each other to define a border encircling the top surface 203t of the contact structure 203 and sides 205s adjoin each other to define a border encircling the top surface 205t of the contact structure 205. In an embodiment, contact structure 203 may comprise at least 5 sides, and at least two of the sides 203s may form an edge 203e that includes a corner 203c that is nearest to the contact structure 205. Contact structure 205 may also comprise at least 5 sides, and at least two of the sides 205s may form an edge 205e that includes a corner 205c that is nearest to the contact structure 203. Corners 203c and 205c may each have an acute angle and may be spaced apart by a distance D, where distance D is the shortest distance between contact structures 203 and 205. Antifuse device 200 may also include dummy structures 207A and 207B each having a different shape from dummy structures 107A and 107B. For example, dummy structures 207A and 207B may each have a diamond-shaped structure each having four sides 207As and 207Bs respectively. Dummy structure 207A may have at least a side 207As facing the nearest side 203s of contact structure 203, and another adjoining side 207As facing the nearest side 205s of contact structure 205. Dummy structure 207B may have at least a side 207Bs facing the nearest side 203s of contact structure 203, and another adjoining side 207Bs facing the nearest side 205s of contact structure 205. Dummy structures 207A and 207B formed are immediately adjacent to and spaced from contact structures 203 and 205 by a distance m, wherein m has a value that is more than the minimum design rule spacing stipulated in the device design as a result of the lithography proximity effect as aforementioned for antifuse device 100. A cross-sectional view of antifuse device 200 taken generally along line A-A' may be similar to that shown in FIG. 1B.

Next referring to FIG. 3B which shows a simplified plan view of antifuse device 300 in accordance with an alternative exemplary embodiment, and in which like reference numerals refer to like features in FIG. 1A. The antifuse device 300 may have features similar to antifuse device 100, but may include contact structures 303 and 305 each having a different shape from contact structures 103 and 105, as well as dummy structures 307A and 307B each having a different shape from dummy structures 107A and 107B. For example, contact structure 303 and contact structure 305 may each have curved or non-linear sides 303s' and 305s' respectively, as well as substantially linear sides 303s and 305s respectively. For each contact, the substantially linear sides and non-linear sides adjoin each other to define a border encircling the top surface of each contact structure. For example, sides 303s and sides 303s' adjoin each other to encircle the top surface 303t of contact structure 303, and sides 305s and sides 303s' adjoin each other to encircle the top surface 305t of the contact structure 305. In an embodiment, contact structure 303 may comprise at least one non-linear side 303s', and at least two of the sides may form an edge 303e that includes a corner 303c that is nearest to the contact structure 305. The sides forming the corner 303c may include one non-linear side 303s' or may include two non-linear sides 303s'. Similarly, contact structure 305 may also comprise at least one non-linear side 305s', and at least two of the sides may form an edge 305e that includes a corner 305c that is nearest to the contact structure 303. Corners 303c and 305c may each have an acute angle and may be spaced apart by a distance D, where distance D is the shortest distance between contact structures 303 and 305. Antifuse device 300 may also include dummy structures 307A and 307B each having a different shape from dummy structures 107A and 107B. For example, dummy structures 307A and 307B may each have a circular-shaped or elliptical-shaped structure each having a non-linear or curved side 307As and 307Bs respectively. Dummy structure 307A may have at least a non-linear or curved side 307As having a side profile that matches or substantially matches the nearest non-linear or curved side 303s' of contact structure 303. The non-linear or curved side 307As may also have a side profile that matches or substantially matches the nearest non-linear or curved side 305s' of contact structure 305. Dummy structure 307B may have at least a non-linear or curved side 307Bs having a side profile that matches or substantially matches the nearest non-linear side 303s' of contact structure 303. The non-linear or curved side 307Bs may have a side profile that matches or substantially matches the nearest non-linear or curved side 305s' of contact structure 305. Dummy structures 307A and 307B formed are immediately adjacent to and spaced from contact structures 303 and 305 by a distance m, wherein m has a value that is more than the minimum design rule spacing stipulated in the device design as a result of the lithography proximity effect as aforementioned for antifuse device 100. A cross-sectional view of antifuse device 300 taken generally along line A-A' may be similar to that shown in FIG. 1B.

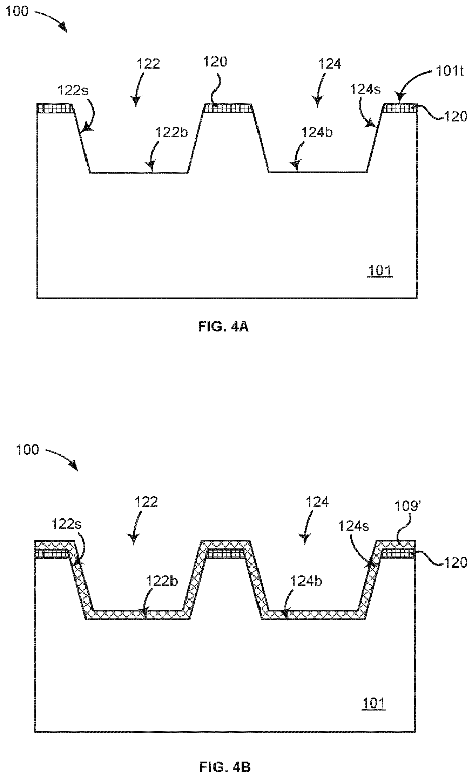

FIGS. 4A - 4D show simplified cross-sectional views representing exemplary process steps for fabricating the antifuse device 100, according to exemplary embodiments of the invention. First referring to FIG. 4A, a mask layer 120 may be formed over the top surface 101t of substrate 101 by a suitable deposition technique, for example, low pressure chemical vapor deposition (LPCVD), or plasma-enhanced chemical vapor deposition (PECVD) processes. The mask layer 120 may be a hard mask material, and may include a dielectric material, such as silicon dioxide or silicon nitride. The mask layer 120 over the substrate 101 may then be patterned by lithography and etching processes to define trenches 122 and 124 for the formation of contact structures 103 and 105, with each trench having a bottom surface 122b and 124b respectively, and at least one adjoining sidewall 122s and 124s respectively. The patterning process may also define trenches (not shown) for the formation of dummy structures 107A and 107B at the same time. As part of the patterning process, an anisotropic material removal process may be utilized, for example, an anisotropic reactive ion etching (RIE) process, or a deep reactive ion etching (DRIE) process. In some embodiments, another patterning mask layer (not shown) may be utilized together with a suitable material removal process and subsequently removed from the top surface of the mask layer 120. It is understood that process limitations may result in slightly sloped sidewalls 122s and 124s for the trenches 122 and 124, as well as rounded edges or corners, in certain instances. In some embodiments, the mask layer 120 may be removed from the top surface 101t of the substrate at a later process stage.

Next referring to FIG. 4B, which shows the antifuse device 100 in an exemplary embodiment after subsequent processing steps to form a barrier liner layer 109' over the substrate 101 and the trenches 122 and 124 so that the sidewalls 122s and 124s are lined with the barrier liner layer 109'. In some embodiments, the barrier liner layer 109' may not be formed and the process may skip directly to the next step to form the conductive material within the trenches. The barrier liner layer 109' may have a nominally uniform thickness and may conformally cover the top surface of the mask layer 120, the sidewalls 122s and 124s, and the bottom surfaces 122b and 124b of the trenches 122 and 124 respectively. The barrier liner layer 109' may also conformally cover the side walls and bottom surfaces of the trenches for the dummy structures 107A and 107B. The term "conformal" may refer to when a material layer conforms to or follows the contours of the surface that the material layer is in direct contact with, while maintaining a relatively uniform thickness over the surface. In some exemplary embodiments, the barrier liner layer 109' may be a single layer liner or include more than two liner layers. The barrier liner layer 109' may include suitable metal or compounds thereof, for example, tantalum nitride, titanium nitride, or any other suitable metals.

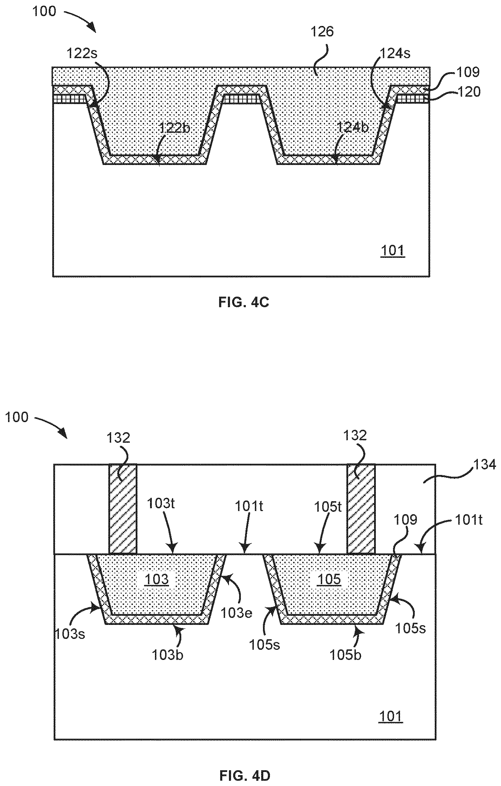

Referring now to FIG. 4C, which shows the antifuse device 100 after subsequent processing steps to form a conductive material 126 over the sidewalls 122s and 124s, and over the bottom surfaces 122b and 124b, and over the top surface 101t of the substrate. In an embodiment, the conductive material 126 may completely fill up the trenches 122 and 124, as well as the trenches for the dummy structures 107A and 107B to a level above the top surface of the barrier liner layer 109' if present, or at least over the top surface of the mask layer 120. Conductive material 126 may include, for example, polysilicon, metal silicides, copper, aluminum, alloys thereof, or any other suitable conductive material.

Referring now to FIG. 4D which shows the antifuse device 100 after subsequent processing steps to partially remove portions of the conductive material, portions of the barrier liner layer 109' if present, and the mask layer 120, to form the resulting contact structures 103 and 105, and vias 132 in dielectric layer 134. A selected material removal process may be used to remove a top portion of the conductive material 126, portions of the barrier liner layer 109' if present, and the mask layer 120. A suitable material removal process may include a chemical mechanical planarization (CMP) process, stopping at the top surface 101t of the substrate. This results in the top surfaces 103t and 105t of the contact structures 103 and 105 respectively, to be coplanar or substantially coplanar with the top surface 101t of the substrate. Conductive lines or vias 132 in the dielectric layer 134 may be formed from a suitable conductive material, using a suitable process, for example, a damascene process.

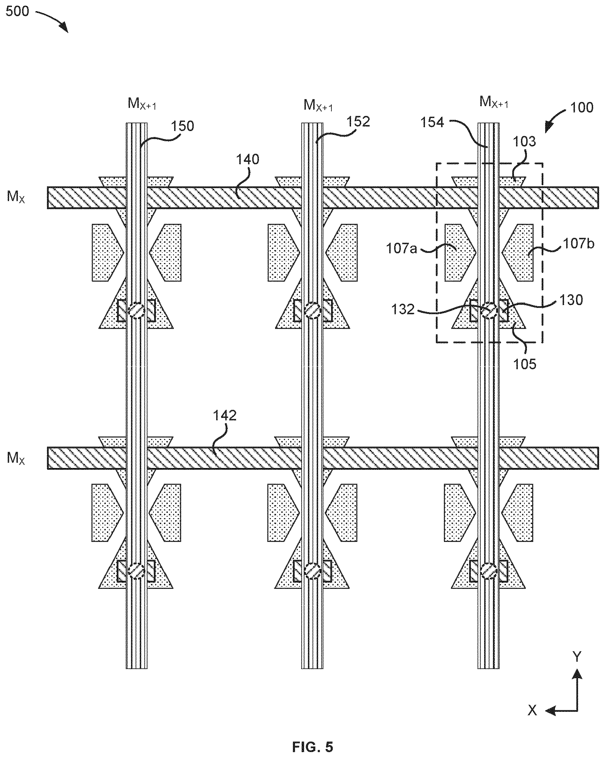

FIG. 5 shows a simplified layout of antifuse devices 100 connected in an array, according to an exemplary embodiment of the invention. A plurality of antifuse devices 100 may be arranged in rows along an X-axis and in columns along a Y-axis, as illustrated in FIG. 5. Each antifuse device 100 may be connected to a metal line located in a metallization level Mx in the back end of line (BEOL) structure and another metal line located in another metallization level Mx+n which may be n levels above the metallization level Mx, where n equals to or more than 1. The antifuse device 100 may be directly connected to the metal line or connected through the via 132 as shown in FIG. 1A. For example, contact structure 103 of antifuse device 100 may be connected directly to metal line 140 located in metallization level Mx, while the contact structure 105 may be connected to metal line 154 through at least conductive structure 130 and via 132. In some embodiments, contact structure 105 may be connected to metal line 154 by either via 132 or conductive structure 130. Metal lines 140 and 142 in metallization level Mx may each be connected to more than one antifuse device arranged in a row along the X-axis. Similarly, metal lines 150, 152, and 154 in metallization level Mx+n may each be connected to more than one antifuse device arranged in a column along the Y-axis.

Descriptions of embodiments herein are meant to be taken as examples and not meant to be limiting as such. Terms such as "vertical", "horizontal", "top", "bottom", "over", "under", and the like in the description and in the claims, if any, are used for establishing a frame of reference and not necessarily for describing permanent relative positions. The term "horizontal" is defined as a plane parallel to a conventional plane of a semiconductor substrate, rather than its actual three-dimensional orientation in space. The terms "vertical" and "normal" refer to a plane perpendicular to the horizontal. The term "lateral" refers to a direction parallel to the horizontal plane.

Terms such as "connected" or "coupled" indicate that a feature may be directly connected or coupled to or with the other feature, or one or more intervening features may also be present. A feature may be "directly connected" or "directly coupled" to or with another feature if intervening features are absent. A feature may be "indirectly connected" or "indirectly coupled" to or with another feature if at least one intervening feature is present. Terms such as "on" or "contacting" indicate that a feature may be directly on or in direct contact with the other feature, or one or more intervening features may also be present. A feature may be "directly on" or in "direct contact" with another feature if intervening features are absent. A feature may be "indirectly on" or in "indirect contact" with another feature if at least one intervening feature is present.

The terms "first", "second", "third" and the like in the description and in the claims, if any, are used for distinguishing between similar elements and not necessarily for describing a particular sequential or chronological order as required. A method described herein is not necessarily limited in practice to the exact order or number of steps as have been listed, and certain steps may possibly be omitted and/or certain other steps not described herein may possibly be performed in actual practice. Terms such as "comprise", "include", "have", and any variations thereof, are intended to cover a non-exclusive inclusion, such that a process, method, article, or device that comprises a list of elements is not necessarily limited to those elements, but may include other elements not expressly listed or inherent to such process, method, article, or device. Occurrences of the phrase "in one embodiment" herein do not necessarily all refer to the same embodiment.

While several exemplary embodiments have been presented in the above detailed description of the device, it should be appreciated that number of variations exist. It should further be appreciated that the embodiments are only examples, and are not intended to limit the scope, applicability, dimensions, or configuration of the device in any way. Rather, the above detailed description will provide those skilled in the art with a convenient road map for implementing an exemplary embodiment of the device, it being understood that various changes may be made in the function and arrangement of elements and method of fabrication described in an exemplary embodiment without departing from the scope of this disclosure as set forth in the appended claims.

In summary, the following embodiments are explicitly disclosed.

### Embodiment 1:

An antifuse device comprising:
a first contact structure in a substrate, the first contact structure having a first contact side and a second contact side adjoining the first contact side, wherein the first contact side and the second contact side form a first contact corner having an acute angle;
a second contact structure in the substrate, wherein the second contact structure is spaced from and not electrically connected to the first contact structure; and
a first dummy structure adjacent to the first contact structure and in the substrate, the first dummy structure having a first dummy side nearest to and spaced from the first contact side of the first contact structure.

### Embodiment 2:

The antifuse device of embodiment 1, wherein at least a portion of the first dummy side is immediately adjacent to the first contact side of the first contact structure.

### Embodiment 3:

The antifuse device of embodiment 1 or 2, further comprising a second dummy structure adjacent to the first contact structure and in the substrate, the second dummy structure having a second dummy side nearest to and spaced from the second contact side of the first contact structure.

### Embodiment 4:

The antifuse device of embodiment 3, wherein at least a portion of the second dummy side is immediately adjacent to the second contact side of the first contact structure.

### Embodiment 5:

The antifuse device of embodiment 2, wherein the portion of the first dummy side is spaced from the first contact side of the first contact structure by a distance more than a minimum design rule spacing.

In some other examples herein, embodiment 5 may be combined with embodiment 3 or 4.

### Embodiment 6:

The antifuse device of one of embodiments 1 to 5, wherein the second contact structure further comprises a third contact side nearest to and spaced from the first dummy structure, and the first dummy structure further comprises a third dummy side nearest to and spaced from the third contact side, wherein at least a portion of the third dummy side is immediately adjacent to the third contact side.

### Embodiment 7:

The antifuse device of one of embodiments 1 to 6, wherein the second contact structure further comprises a third contact side nearest to and spaced from the first dummy side, wherein at least a portion of the first dummy side is immediately adjacent to the third contact side of the second contact structure.

### Embodiment 8:

The antifuse device of one of embodiments 1 to 7, wherein the first contact corner is nearest to the second contact structure compared to the rest of the first contact structure.

### Embodiment 9:

The antifuse device of one of embodiments 1 to 8, wherein the substrate has a top surface, the first contact structure has a top surface, the second contact structure has a top surface, and the top surfaces of the substrate, the first contact structure and the second contact structure are substantially coplanar.

### Embodiment 10:

The antifuse device of embodiment 9, wherein the first dummy structure has a top surface and the top surface of the first dummy structure is substantially coplanar with the top surface of the substrate.

### Embodiment 11:

The antifuse device of one of embodiments 1 to 10, wherein the first contact structure has a top surface and a bottom surface, and the bottom surface has a smaller area than the top surface.

### Embodiment 12:

The antifuse device of one of embodiments 1 to 11, further comprising:
a second dummy structure adjacent to the first contact structure and in the substrate,
wherein the first dummy structure has the first dummy side nearest to and spaced from the first contact side of the first contact structure by a first spacing,
wherein the second dummy structure has a second dummy side nearest to and spaced from the second contact side of the first contact structure by a second spacing, and
wherein the first spacing is substantially the same as the second spacing.

### Embodiment 13:

An antifuse device comprising:
a first contact structure in a substrate, the first contact structure having a first contact side and a second contact side adjoining the first contact side, wherein the first contact side and the second contact side form a first contact corner having an acute angle;
a second contact structure in the substrate, wherein the second contact structure is spaced from and not electrically connected to the first contact structure;
a first dummy structure adjacent to the first contact structure and in the substrate, the first dummy structure having a first dummy side nearest to and spaced from the first contact side of the first contact structure by a first spacing; and
a second dummy structure adjacent to the first contact structure and in the substrate, the second dummy structure having a second dummy side nearest to and spaced from the second contact side of the first contact structure by a second spacing, and wherein the first spacing is substantially the same as the second spacing.

### Embodiment 14:

The antifuse device of embodiment 12 or 13, wherein the first contact side and the second contact side are linear.

### Embodiment 15:

The antifuse device of one of embodiments 12 to 14, wherein the first contact side and the second contact side are curved.

### Embodiment 16:

The antifuse device of embodiment 14, wherein the first dummy side is linear and substantially parallel to the first contact side.

### Embodiment 17:

The antifuse device of embodiment 15, wherein the first dummy side is curved and substantially parallel to the first contact side.

### Embodiment 18:

The antifuse device of one of embodiments 12 to 17, wherein the second contact structure has an edge nearest to the first contact structure and the first contact corner is nearest to and spaced from the edge.

### Embodiment 19:

A method of fabricating an antifuse device comprising:
forming a first contact structure in a substrate, the first contact structure having a first contact side and a second contact side adjoining the first contact side, wherein the first contact side and the second contact side form a first contact corner having an acute angle;
forming a second contact structure in the substrate, wherein the second contact structure is spaced from and not electrically connected to the first contact structure; and
forming a first dummy structure adjacent to the first contact structure and in the substrate, the first dummy structure having a first dummy side nearest to and spaced from the first contact side of the first contact structure.

### Embodiment 20:

A method according to embodiment 19, wherein the first contact structure has a top surface and a bottom surface, and the bottom surface has a smaller area than the top surface.

### Embodiment 21:

A method according to embodiment 19 or 20, further comprising a chemical mechanical planarization process in the forming of the first contact structure, the second contact structure, and the first dummy structure.

### Embodiment 22:

The method according to one of embodiments 19 to 21, wherein the antifuse device of one of embodiments 1 to 18.

In accordance with some examples of the embodiments 1 to 20 above, an antifuse device may be provided, the antifuse device having a first contact structure and a second contact structure in a substrate. The first contact structure may have a first contact side adjoining a second contact side and forming a first contact corner having an acute angle. The second contact structure may be spaced from and not electrically connected to the first contact structure. The antifuse device may further include a first dummy structure in the substrate, adjacent to the first contact structure. The first dummy structure may have a first dummy side nearest to and spaced from the first contact side of the first contact structure. At least in the embodiments above, the term "include" and its variants may be interpreted as meaning that an embodiment includes stated features, while not necessarily excluding the presence of other features that are not explicitly stated.

The term substantially may either denote an exact quantity or condition or it may account for acceptable tolerances applying in the art. For example, tolerances may be in a range up to 25% of a given value or condition, indicating a variance of the given value or condition to at least a side of the value or a state of approaching the condition up to the acceptable tolerance, preferably up to 15% or 10% or 5% or 1%.

## Claims

1. An antifuse device comprising:
a first contact structure in a substrate, the first contact structure having a first contact side and a second contact side adjoining the first contact side, wherein the first contact side and the second contact side form a first contact corner having an acute angle;
a second contact structure in the substrate, wherein the second contact structure is spaced from and not electrically connected to the first contact structure; and
a first dummy structure adjacent to the first contact structure and in the substrate, the first dummy structure having a first dummy side nearest to and spaced from the first contact side of the first contact structure.

2. The antifuse device of claim 1, wherein at least a portion of the first dummy side is immediately adjacent to the first contact side of the first contact structure, wherein the portion of the first dummy side is preferably spaced from the first contact side of the first contact structure by a distance more than a minimum design rule spacing.

3. The antifuse device of claim 1 or 2, wherein the second contact structure further comprises a third contact side nearest to and spaced from the first dummy structure, and the first dummy structure further comprises a third dummy side nearest to and spaced from the third contact side, wherein at least a portion of the third dummy side is immediately adjacent to the third contact side.

4. The antifuse device of claim 1 or 2, wherein the second contact structure further comprises a third contact side nearest to and spaced from the first dummy side, wherein at least a portion of the first dummy side is immediately adjacent to the third contact side of the second contact structure.

5. The antifuse device of one of claims 1 to 4, wherein the first contact corner is nearest to the second contact structure compared to the rest of the first contact structure.

6. The antifuse device of one of claims 1 to 5, wherein the substrate has a top surface, the first contact structure has a top surface, the second contact structure has a top surface, and the top surfaces of the substrate, the first contact structure and the second contact structure are substantially coplanar, the first dummy structure preferably having a top surface and the top surface of the first dummy structure preferably being substantially coplanar with the top surface of the substrate.

7. The antifuse device of one of claims 1 to 6, wherein the first contact structure has a top surface and a bottom surface, and the bottom surface has a smaller area than the top surface.

8. The antifuse device of one of claims 1 to 7, further comprising a second dummy structure adjacent to the first contact structure and in the substrate, the second dummy structure having a second dummy side nearest to and spaced from the second contact side of the first contact structure, at least a portion of the second dummy side preferably being immediately adjacent to the second contact side of the first contact structure.

9. The antifuse device of one of claims 1 to 7, further comprising:
a second dummy structure adjacent to the first contact structure and in the substrate,
wherein the first dummy structure has the first dummy side nearest to and spaced from the first contact side of the first contact structure by a first spacing,
wherein the second dummy structure has a second dummy side nearest to and spaced from the second contact side of the first contact structure by a second spacing, and
wherein the first spacing is substantially the same as the second spacing.

10. The antifuse device of claim 9, wherein the first contact side and the second contact side are linear, the first dummy side preferably being linear and substantially parallel to the first contact side.

11. The antifuse device of claim 9 or 10, wherein the first contact side and the second contact side are curved, the first dummy side preferably being curved and substantially parallel to the first contact side.

12. The antifuse device of one of claims 9 to 11, wherein the second contact structure has an edge nearest to the first contact structure and the first contact corner is nearest to and spaced from the edge.

13. A method of fabricating an antifuse device, preferably the antifuse device of one of claims 1 to 12, the method comprising:
forming a first contact structure in a substrate, the first contact structure having a first contact side and a second contact side adjoining the first contact side, wherein the first contact side and the second contact side form a first contact corner having an acute angle;
forming a second contact structure in the substrate, wherein the second contact structure is spaced from and not electrically connected to the first contact structure; and
forming a first dummy structure adjacent to the first contact structure and in the substrate, the first dummy structure having a first dummy side nearest to and spaced from the first contact side of the first contact structure.

14. A method according to claim 13, wherein the first contact structure has a top surface and a bottom surface, and the bottom surface has a smaller area than the top surface.

15. A method according to claim 13 or 14, further comprising a chemical mechanical planarization process in the forming of the first contact structure, the second contact structure, and the first dummy structure.
